# EUROPEAN PATENT APPLICATION

(11) **EP 2 648 232 A1**
(43) Date of publication of application: **09.10.2013**
(21) Application number: 11844619.4
(22) Date of filing: 25.11.2011
(51) Int. Cl.: H01L 31/052

(54) **SOLAR CELL SYSTEM**

(30) Priority: 30.11.2010 JP 2010267818
(71) Applicant: Daikin Industries, Ltd., Osaka 530-8323 (JP)
(72) Inventor: CHIDA, Akira, 40210 Düsseldorf (JP); THIEMANN, Ansgar, Walpurgisstr. 42 45131 Essen (BE)
(74) Representative: HOFFMANN EITLE
(86) International application number: PCT/JP2011/077148
(87) International publication number: WO 2012/073806

(57) **Abstract**

Provided is a solar cell system equipped with a layer of excellent weatherability, soiling resistance, and light reflecting properties. The solar cell system (100) is equipped with solar cells (10) and a reflecting panel (20) disposed on the opposite side from the sunlight-incidence side of the solar cells (10). The reflecting panel (20) has a coating film (21) containing a fluororesin and a light-reflectiving pigment.

## Description

### TECHNICAL FIELD

The present invention relates to a solar cell system.

### BACKGROUND ART

In the past, there has been proposed a backsheet for solar cells installed outdoors, which has the function of minimizing infiltration of moisture into the interior of the solar cells, affording good weatherability, as disclosed for example in Patent Document 1 (Japanese Laid-Open Patent Application 2007-35694).

### SUMMARY OF THE INVENTION

### <Technical Problem>

The solar cell disclosed in the aforementioned Patent Document 1 (Japanese Laid-Open Patent Application 2007-35694) receives light only at side where sunlight is incident.

In contrast, there have been devised solar cell systems of so-called "see-through" type, in which a reflecting panel is disposed to the rear surface side, as a separate member from the solar cells. In such a solar cell system, light having passed through the solar cells is reflected by the reflecting panel, and the reflected light is received at the rear surface side of the solar cells, thereby improving the power generation efficiency. Moreover, due to the ease of processing and handling, as well as low cost, as the reflecting panel there is typically utilized one made of a general purpose hydrocarbon resin such as polyester, polyolefin, urethane, vinyl chloride, or the like.

Because such reflecting panels for solar cells are utilized while installed in environments where they receive as much sunlight as possible, reflecting panels made of the conventional hydrocarbon resins are prone to degrade over the years, due to insufficient weatherability. Such degradation of a reflecting panel may lead to diminished light reflecting ability of the reflecting panel as well.

Moreover, reflecting panels are utilized in environments where they are prone to becoming soiled by exhaust gases from cars, dust, exhaust gases from factories, and the like, and such soiling of the surface of a reflecting panel can lead to diminished light reflecting ability.

Once the light reflecting ability of a reflecting panel has been diminished in the above manner, good power generation efficiency of the solar cells cannot be maintained. Moreover, because there are cases in which the reflecting panel itself is used inclusively as part of a constituent member of a structure (for example, a roof or wall), such degradation is undesirable from the standpoint of maintaining the durability of the structure as well.

With the foregoing in view, it is an object of the present invention to provide a solar cell system equipped with a reflecting layer, whereby it is possible for weatherability, soiling resistance, and sunlight reflecting properties to be maintained for prolonged periods.

### <Solution to Problem>

A solar cell system according to a first aspect of the present invention is equipped with solar cell, and a reflecting layer. The reflecting layer is disposed on the opposite side from the sunlight-incidence side of the solar cell. The reflecting layer includes a fluororesin, and a light-reflectiving pigment.

A solar cell system according to a second aspect of the present invention is the solar cell system according to the first aspect of the present invention, wherein the solar cell has a power generating element having a first photoreceptor part for receiving light on the sunlight-incidence side, and a second photoreceptor part for receiving light at the opposite side from the sunlight-incidence side.

A solar cell system according to a third aspect of the present invention is the solar cell system according to the first or second aspect of the present invention, wherein the fluororesin is a fluoro-olefin polymer having normal-temperature coating properties or melt molding properties.

A solar cell system according to a fourth aspect of the present invention is the solar cell system according to any of the first to third aspects of the present invention, wherein the reflecting layer has a solar reflectance of 50% or higher in the 780-2500 nm wavelength range, as determined by the method of JIS K5602 (2008).

A solar cell system according to a fifth aspect of the present invention is the solar cell system according to any of the first to fourth aspects of the present invention, wherein the reflecting layer is disposed at a distance from the solar cell.

A solar cell system according to a sixth aspect of the present invention is the solar cell system according to any of the first to fifth aspects of the present invention, further comprising a base material, the reflecting layer being a coating film formed on the surface of the base material.

A solar cell system according to a seventh aspect of the present invention is the solar cell system according to any of the first to fifth aspects of the present invention, wherein the reflecting layer is a molded resin formed by melt processing a thermoplastic fluororesin into which a light-reflectiving pigment is admixed; or the reflecting layer has an inorganic fabric, the reflecting layer being constituted by melt processing of a thermoplastic fluororesin into which a light-reflectiving pigment is admixed, and supported on the inorganic fabric.

### <Advantageous Effects of Invention>

The present invention can afford good weatherability, soiling resistance, and light reflecting properties of the reflecting layer in the solar cell system, thereby making it possible for good power generation efficiency to be maintained.

### BRIEF DESCRIPTION OF THE DRAWINGS

FIG. 1 is a schematic cross sectional view of a first embodiment of the solar cell system of the present invention.
FIG. 2 is a schematic plan view of the first embodiment of the solar cell system of the present invention.
FIG. 3 is a schematic exterior perspective view of the first embodiment of the solar cell system of the present invention.
FIG. 4 is a schematic exterior perspective view of a second embodiment of the solar cell system of the present invention.
FIG. 5 is a schematic cross sectional view of a third embodiment of the solar cell system of the present invention.
FIG. 6 is a schematic cross sectional view of a fourth embodiment of the solar cell system of the present invention.
FIG. 7 is a schematic cross sectional view of a fifth embodiment of the solar cell system of the present invention.
FIG. 8 is a schematic cross sectional view of a sixth embodiment of the solar cell system of the present invention.
FIG. 9 is a schematic cross sectional view of a seventh embodiment of the solar cell system of the present invention.

### DESCRIPTION OF EMBODIMENTS

The solar cell system of the present invention is equipped with solar cells and a reflecting layer.

The solar cell is not limited to any particular type, and the constituent material thereof may be, for example, a silicon-based one employing crystalline silicon or the like; a compound semiconductor based one employing a rare metal or the like; or an organic based one containing an organic substance. As regards the form of the cell, a thin film type, hybrid type, multi-junction type, or spherical type is acceptable. There are no particular limitations as to the installation location for the solar cell, provided that the position is one at which reflected light can be received from the reflecting layer; for example, disposition on a roof terrace of a building, on top of a roof, on top of a vehicle, or the like would be acceptable; or with the solar cells serving as a wall, window, eave, or the like, the reflecting layer may be disposed to the opposite side thereof in relation to the sun.

There are no particular limitations as to the reflecting layer, provided that it is disposed beneath the solar cells, and includes a fluororesin and a light-refectiving pigment. Any of a number of forms, for example, a coating film formed by application of a coating compound onto an structural base material in advance, and/or a coating film formed by application of a coating compound onto part of an existing structure (for example, a roof and/or a wall surface and/or a window or the like), and/or instead of a coating, a molded resin member (for example, a film material, board, or the like) obtained by admixture of a light-reflectiving pigment into a thermoplastic fluororesin, are acceptable. Coating films may be formed by application of a coating compound onto an existing exterior surface of a roof and/or a wall already at the site where the solar cells will be installed; or formed by a preformed film or sheet profile, disposed by lamination on-site using known techniques. Additionally, during the process, the existing old surface layer of the roof and/or wall surface may be removed prior to formation through coating or disposition by lamination in the same manner as described above. Molded resin members <employed instead of> coatings will include a fluororesin and a light-reflectiving pigment, and may be formed using known molding methods. Among these various treatment techniques, techniques involving formation of the reflecting layer through application and drying of a coating compound are preferred for ease of procedure, through direct treatment of an existing structure. The reflecting layer may be constituted, for example, by compound layers of a layer containing a light-reflectiving pigment, a layer containing a fluororesin furnished on the surface layer thereof; or constituted as a single layer in which a fluororesin and a light-reflectiving pigment are present together.

While the solar cells and the reflecting layer shall be described hereinbelow with reference to specific examples, the solar cell system of the present invention is not limited to these.

### <1> First Embodiment

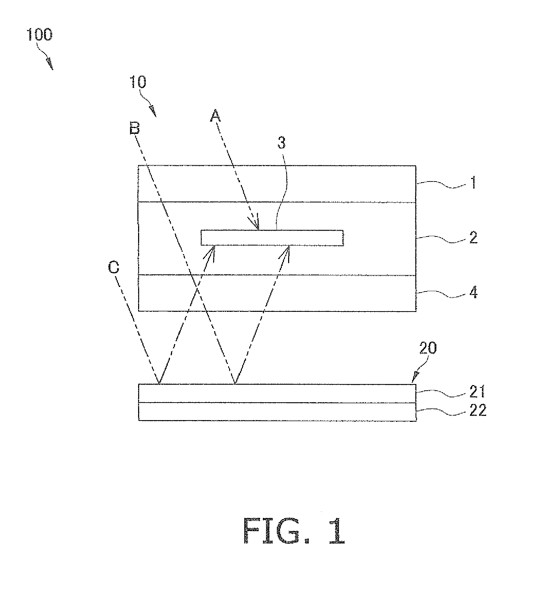

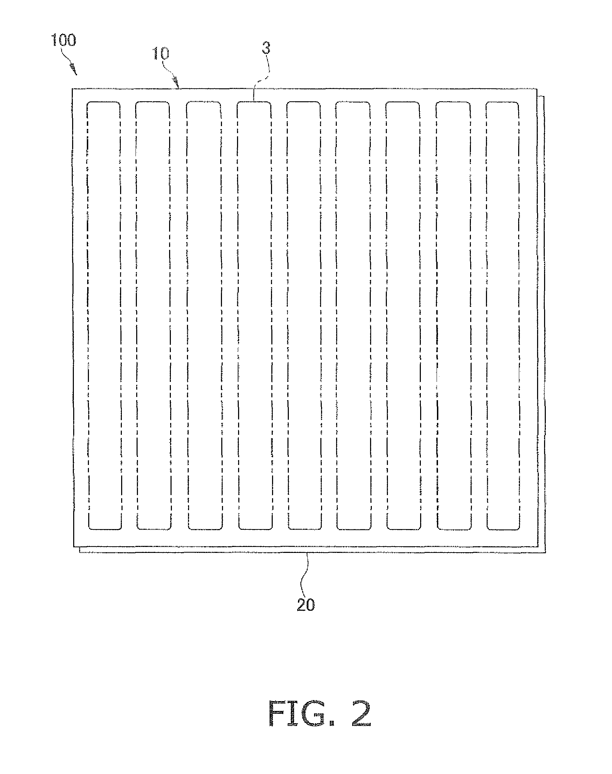

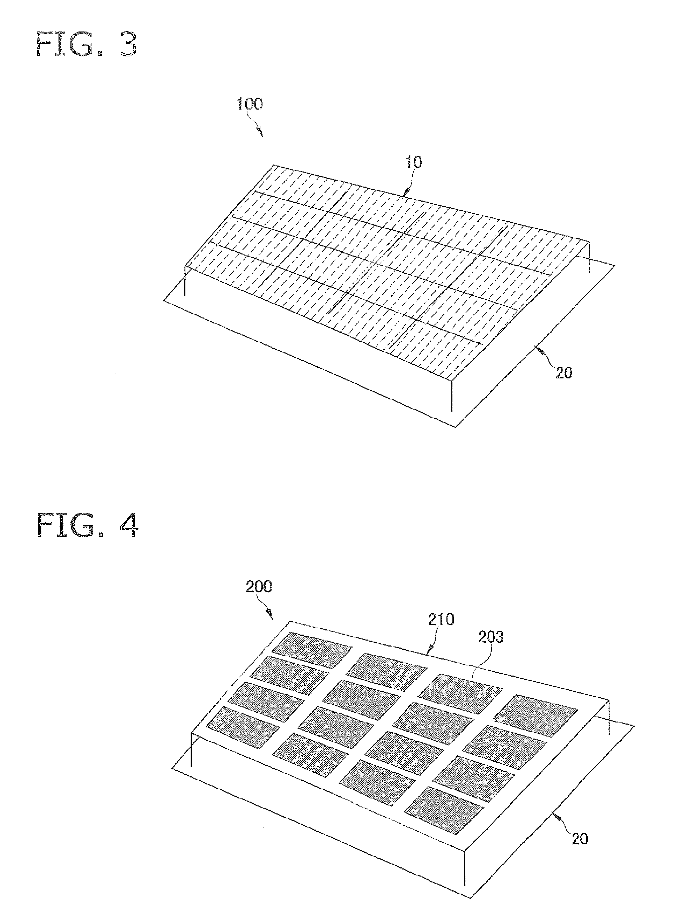

As shown in cross sectional view in FIG. 1, in plan view in FIG. 2, and in exterior schematic perspective view in FIG. 3, the solar cell system 100 according to a first embodiment of the present invention is equipped with solar cells 10, and a reflecting panel 20, as a light-reflecting film for the solar cell.

### <1-1> Constitution of Solar Cells 10

A plurality of the solar cells 10 are arrayed at predetermined spacing such that the lengthwise directions thereof are mutually parallel, and disposed above the reflecting panel 20 at a distance from the reflecting panel 20.

Herein, "front side" shall indicate the sunlight-incidence side, and "back side" shall indicate the reflected sunlight-incidence side.

As shown in FIG. 1, the solar cells 10 are constituted by a front surface protection layer 1, a sealing layer 2, and a back surface protection layer 4, stacked in that order from the sunlight-incidence side. A power generating element 3 is disposed in the interior of the sealing layer 2. Depending on the intended purpose, the solar cells 10 may be furnished with another layer, as a surface layer or intervening layer.

The front surface protection layer 1 is furnished in order to protect the solar cell 10 from the front side, and is constituted, for example, by light-transmissive glass or resin.

The power generating element 3 is furnished with a photoreceptor part having a front side photoreceptor part (first photoreceptor part) and a back side photoreceptor part (second photoreceptor part), so as to be able to generate power from light received not just at the front side, but at the back side as well. As shown in plan view in FIG. 2, the power generating elements 3 of the present embodiment are disposed arrayed with their lengthwise directions thereof mutually parallel, with predetermined spacing therebetween such that there is no overlap.

The back surface protection layer 4 is furnished in order to protect the solar cell 10 from the back side, and is constituted, for example, by light-transmissive glass or resin.

The sealing layer 2 is constituted by filling the space between the front surface protection layer 1 and the back surface protection layer 4 with a light-transmissive filler, so as to cover up the surrounding area of the power generating element 3. As the filler, there may be cited materials that crosslink and cure when heated and melted, for example, ethylenevinyl acetate copolymer (EVA) or the like. The front surface protection layer 1, the back surface protection layer 4, and the power generating element 3 can be unified by heating and melting such a filler.

### <1-2> Constitution of Reflecting Panel 20

As shown in FIG. 1, the reflecting panel 20 is disposed beneath the solar cells 10 at a distance from the solar cells 10, and has the function of reflecting light that has passed through the solar cells 10 or the surrounding area. Because the light reflected by the reflecting panel 20 is directed to the back surface side of the power generating element 3, the quantity of light received by the power generating element 3 can be increased.

The reflecting panel 20 is constituted from a coating film 21 and a base material 22. With regard to the shape of the reflecting panel 20, it may be formed flat, or formed so as to curve to a certain extent. Asperities may be formed on the surface, or a smooth surface may be formed.

The coating film 21 (reflecting layer) is constituted so as to contain a fluororesin as the coating film-forming component, and a light-reflectiving pigment for conferring sunlight-reflecting functionality. If needed, a middle coating film, a base coating film, or a sealer layer may be furnished as undercoats for the light-reflecting coating layer.

The base material 22 is constituted primarily of a polyester, polyolefin, or polyurethane resin.

### <1-3> Features of the First Embodiment

As shown in FIG. 1, in the solar cell system 100 of the first embodiment, at the front side of the solar cells 10, sunlight A is transmitted through the front surface protection layer 1 and the sealing layer 2, and is thereby received by the power generating element 3 from the front side.

Moreover, as shown in FIG. 1, at the back side of the solar cells 10, sunlight B reflected by the reflecting panel 20 is transmitted through the back surface protection layer 4 and the sealing layer 2, and is thereby received by the power generating element 3 from the back side. Furthermore, at the back side of the solar cells 10, sunlight C not transmitted through the solar cells 10 is likewise reflected by the reflecting panel 20, and transmitted through the back surface protection layer 4 and the sealing layer 2, to be received by the power generating element 3 from the back side.

In this way, in the solar cell system 100, the power generating elements 3 of the solar cells 10 can receive light not only at the front side but at the back side as well, increasing the power generation efficiency.

Because the coating film 21 of the reflecting panel 20 is constituted so as to contain a light-reflectiving pigment, good light reflecting properties can be had. Moreover, because the coating film 21 is constituted so as to contain a fluororesin, good weatherability and soiling resistance can be maintained, and good light reflecting properties can be maintained for prolonged periods. Therefore, the solar cell system 100 can maintain good conditions of light reception at the back side, thereby making it possible to maintain good power generation efficiency for prolonged periods.

Also, because the solar cells 10 and the reflecting panel 20 are disposed at a distance from one another, it is possible for air to pass between the solar cells 10 and the reflecting panel 20. In this case, high-temperature air accumulating between the solar cells 10 and the reflecting panel 20 can be diffused, thereby cooling down the solar cells 10. In so doing, increased electrical resistance in the internal constitution, caused by high temperature of the solar cells 10, can be minimized, which is advantageous in terms of improving the power generation efficiency as well.

Also, because the reflecting panel 20 is constituted so as to employ the base material 22, even in cases in which the coating film 21 constituted by the fluororesin and the light-reflectiving pigment is thin, the shape stability is excellent, while making it possible to keep to a minimum the amounts in which the fluororesin and the light-reflectiving pigment are used.

### <2> Second Embodiment

The description of the solar cell system 1000 of the aforedescribed first embodiment cited as an example a case of solar cells 10 having a plurality of power generating elements 3 disposed arrayed so as to be mutually parallel in the lengthwise direction.

However, the present invention is not limited to this arrangement.

For example, a solar cell system 200 equipped with solar cells 210 in which a plurality of generally rectangular power generating elements 203 are disposed arrayed longitudinally and laterally at predetermined spacing, such that there is no mutual overlap, as shown in FIG. 4, would also be acceptable. The constitution is otherwise the same as in the first embodiment.

In this case, as in the aforedescribed first embodiment, light having passed through sections between the power generating elements 203 of the solar cells 210 and/or light incident from the surrounding areas of the solar cells 210 is reflected by the reflecting panel 20, whereby the power generating elements 203 receive light not just at front face side but at the back face side as well, improving the power generation efficiency.

### <3> Third Embodiment

In the aforedescribed first embodiment and the like, there was cited as an example a case in which the back surface protection layer 4 is light transmissive.

However, the present invention is not limited to this arrangement.

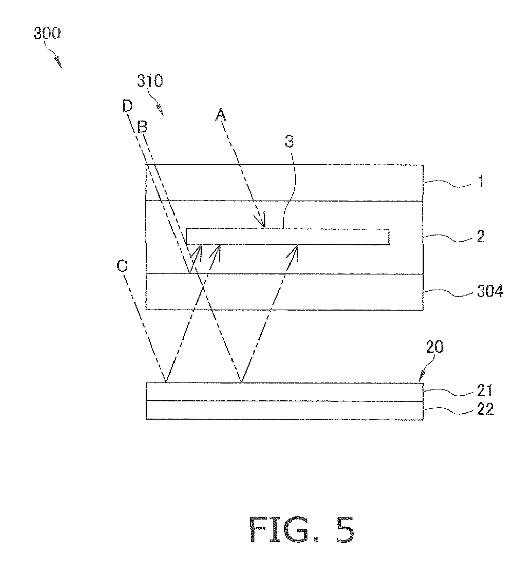

For example, a solar cell system 300 equipped with solar cells 310 having a back surface protection layer 304 that reflects some light, as shown in FIG. 5, would also be acceptable. The constitution is otherwise the same as in the first embodiment.

The power generating element 3 of the solar cell 310, at the front side thereof, can receive sunlight A having passed through the front surface protection layer 1 and the sealing layer 2, while at the back side, can receive sunlight B reflected by the reflecting panel 20 after having passed through the solar cell 310, sunlight C reflected by the reflecting panel 20 without having passed through the solar cell 310, and sunlight D reflected by the back surface protection layer 304.

In cases is which the back surface protection layer 304 has degraded over the years so that the light reflecting properties are no longer good, light reflecting properties cannot be restored even when the back surface protection layer 304 of the solar cell 310 is reapplied from the back side of the solar cell 310; and in cases in which the back surface protection layer 304 is stripped and applied again, there is a risk of damaging the power generating element 3. In contrast, in the solar cell system 300, light reflecting properties can be restored by re-furnishing a reflecting layer (of any form, such as a coating film and/or a sheet or the like) containing a fluororesin and a light-reflectiving pigment, to a target (for example, the reflecting panel 20) disposed beneath the solar cell 310. Moreover, even when the reflecting panel 20 has degraded over the years when employed for a very long period of time, light reflecting properties can be restored by forming a further reflecting layer on the surface layer thereof.

### <4> Fourth Embodiment

In the aforedescribed first to third embodiments, there were cited as examples cases in which the reflecting panel 20 has the coating film 21 containing a fluororesin and a light-reflectiving pigment.

However, the present invention is not limited to this arrangement.

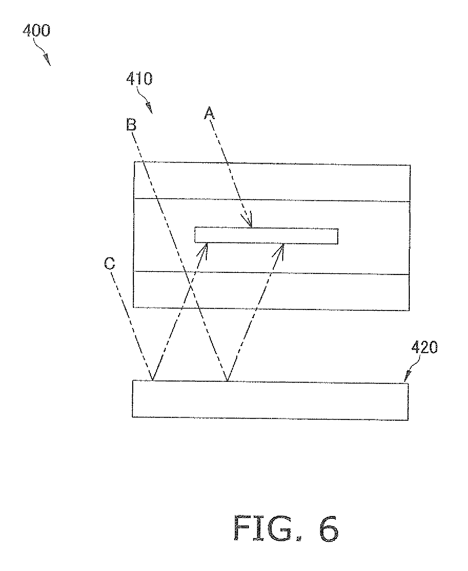

For example, a solar cell system 400 equipped with solar cells 410 and with a reflecting panel 420 formed of a material in which a fluororesin and a light-reflectiving pigment have been admixed together, as shown in FIG. 6, would also be acceptable.

The constitution of the solar cells 410 of the fourth embodiment may be a constitution comparable to that of the solar cells 10 of the first embodiment, a constitution comparable to that of the solar cells 210 of the second embodiment, or a constitution comparable to that of the solar cells 310 of the third embodiment.

### <5> Fifth Embodiment

In the respective aforedescribed first to third embodiments, cases in which the reflecting panel 20 has the coating film 21 containing a fluororesin and a light-reflectiving pigment, and in the aforedescribed fourth embodiment, a case in which the reflecting panel 420 is formed of a material containing a fluororesin and a light-reflectiving pigment, are described.

However, the present invention is not limited to this arrangement.

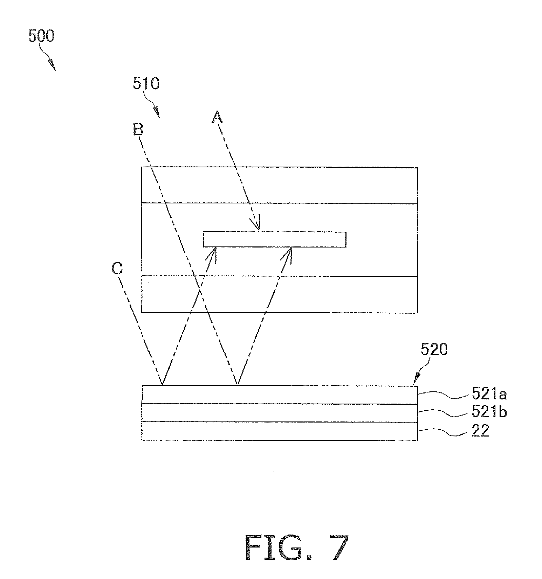

For example, a solar cell system 500 equipped with a reflecting panel 520 and solar cells 510, as shown in FIG. 7, would also be acceptable. This reflecting panel 520 is constituted so as to have a base material 22 the same as that in the aforedescribed embodiments, a front surface film 521a formed of a material containing a fluororesin, and a reflecting layer 521b furnished between the base material 22 and the front surface film 521a, and formed of a material containing a light-reflectiving pigment.

The constitution of the solar cells 510 of the fifth embodiment may be a constitution comparable to that of the solar cells 10 of the first embodiment, a constitution comparable to that of the solar cells 210 of the second embodiment, or a constitution comparable to that of the solar cells 310 of the third embodiment.

### <6> Sixth Embodiment

In the aforedescribed first to fifth embodiments, there were cited as examples cases in which a layer containing a fluororesin is formed on the base material 22.

However, the present invention is not limited to this arrangement.

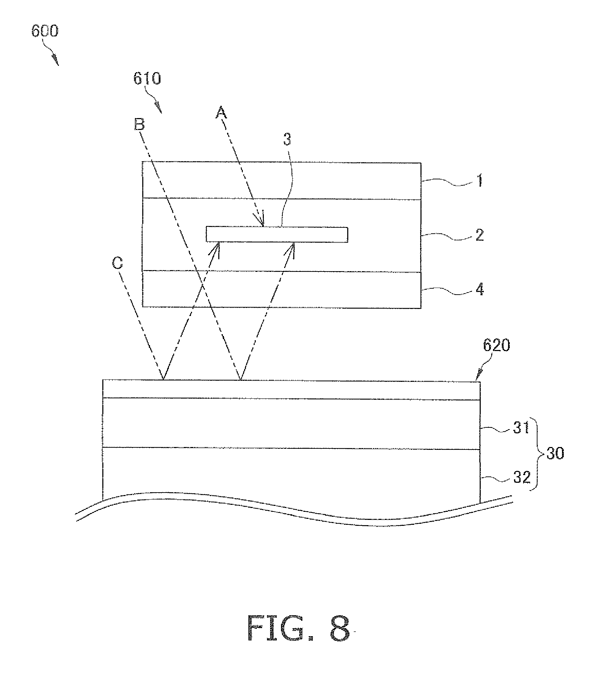

For example, a solar cell system 600 equipped with solar cells 610, a coating film 620, and a roof 30 of a building, as shown in FIG. 8, would also be acceptable. The coating film 620 containing a fluororesin and a light-reflectiving pigment is formed an exterior surface of a roof 30.

The roof 30 of the building is constituted by a panel member 31 and/or a heat insulation material 32, and/or metal and/or concrete, not shown. This panel member 31 is constituted, for example, primary from a polyester, polyolefin, or polyurethane resin.

The coating film 620 is obtained by applying a coating compound containing a fluororesin and a light-reflectiving pigment, and drying it.

In the solar cell system 600 of the sixth embodiment, simply by forming the coating film 620 on the roof 30, it is possible to utilize light from the back side of the solar cells 610 to generate power; a separate base material may not be furnished unlike the aforedescribed first to fifth embodiments. Moreover, even when the surface of the roof 30, prior to formation of the coating film 620 thereon, has a shape having asperity or has a curving shape, the coating film 620 is readily formed through application of a coating compound, making it possible to generate power at the back side of the solar cells 610.

The constitution of the solar cells 610 of the sixth embodiment may be a constitution comparable to that of the solar cells 10 of the first embodiment, a constitution comparable to that of the solar cells 210 of the second embodiment, or a constitution comparable to that of the solar cells 310 of the third embodiment.

### <7> Seventh Embodiment

In the aforedescribed sixth embodiment, there was cited as an example a case in which the coating film 620 is constituted so as to contain a fluororesin and a light-reflectiving pigment.

However, the present invention is not limited to this arrangement.

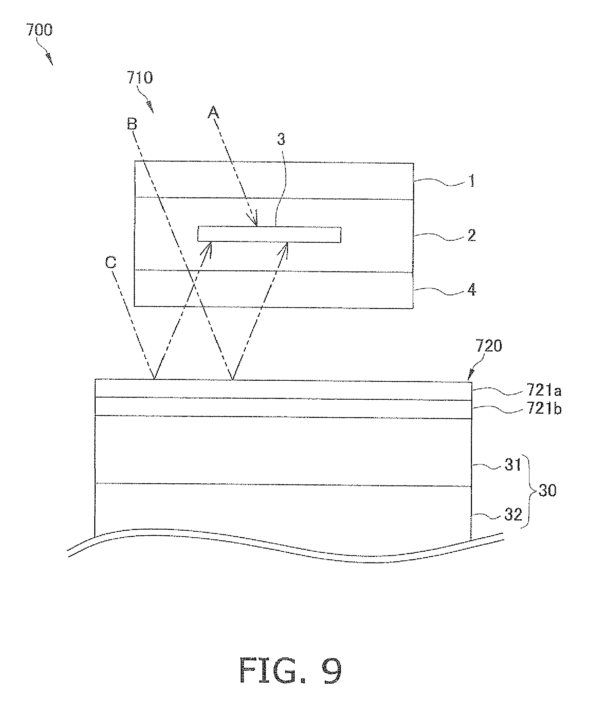

For example, a solar cell system 700 equipped with solar cells 710, a coating film layer 720 and a roof 30 of a building, as shown in FIG. 9, would also be acceptable. The coating film layer 720 is formed an exterior surface of the roof 30.

This coating film layer 720 is constituted so as to have a front surface film 721a formed of a material containing a fluororesin, and a reflecting layer 721b formed of a material containing a light-reflectiving pigment.

The roof 30 of the building is comparable to that in the aforedescribed sixth embodiment.

The coating film layer 720 is obtained by applying and drying a coating compound containing a light-reflectiving pigment, thereby forming the reflecting layer 721b, and then applying a coating compound containing a fluororesin thereover (if needed, interposing another layer if needed) and drying it, thereby forming the front surface film 721a.

In the solar cell system 700 of the seventh embodiment, simply by forming the coating film layer 720 on the roof 30, it is possible to utilize light from the back side of the solar cells 710 to generate power; a separate base material may not be furnished unlike the aforedescribed first to fifth embodiments. Moreover, even when the surface of the roof 30, prior to formation of the coating film layer 720 thereon, has a shape having asperity, or has a curving shape, the coating film layer 720 is readily formed through application of a coating compound, making it possible to generate power at the back side of the solar cells 710.

The constitution of the solar cells 710 of the seventh embodiment may be a constitution comparable to that of the solar cells 10 of the first embodiment, a constitution comparable to that of the solar cells 210 of the second embodiment, or a constitution comparable to that of the solar cells 310 of the third embodiment.

### <8> Details of the Coating Film 21 as in the First to Third Embodiments and the Coating Film 620 as in the Sixth Embodiment

The coating film 21 as in the first to third embodiments and the coating film 620 as in the sixth embodiment (in section <8>, hereinafter termed "coating films") are obtained by application and drying of a coating compound composition containing a fluororesin and a light-reflectiving pigment. While specific examples of fluororesins and light-reflectiving pigments are cited in the following description, there is no limitation to these.

### <8-1> Fluororesins

The fluororesin is preferably a fluororesin that is coatable at normal temperature, or melt moldable at temperatures at or above the melting point but less than 400°C. As nonlimiting examples of such fluororesins, there may be cited, for example, polymers such as those disclosed in Japanese Laid-Open Patent Application 2010-247522 (paragraph <0023>). Due to properties such as excellent weatherability, water resistance, chemical resistance, resistance to soiling, and the like, polyvinylidene fluoride (PVdF), vinylidene fluoride (VdF)/tetrafluoroethylene copolymer (TFE), VdF/TFE/hexafluoropropylene (HFP) copolymer, VdF/TFE/chlorotrifluoroethylene (CTFE) copolymer, polytetrafluoroethylene (PTFE), TFE/perfluoro(alkyl vinyl ether) (PAVE) copolymer (PFA), ethylene (Et)/TFE copolymer (ETFE), polychlorotrifluoroethylene (PCTFE), and other such fluoro-olefin polymers; curing functional group-containing fluoro-olefin polymers copolymerized from TFE and/or CTFE, HFP, or other such fluoro-olefin and a functional group-containing monomer, or the like, are preferred. Of these, solvent-soluble type fluororesins, or aqueous dispersion type fluororesins that are dispersible in water, and having excellent normal-temperature coating properties, are particularly preferred from the standpoint of the ease of on-site treatment properties.

### <8-1-1> Solvent-soluble Fluororesins

Due to properties such as excellent weatherability, solvent-solubility, curing properties, chemical resistance, transparency, ease of production, ease of coating compound preparation, ease of coating operation, and the like, the curing functional group-containing fluoro-olefin polymers disclosed in Japanese Laid-Open Patent Application 2007-35694 (paragraphs <0024>-<0050>) are preferred as solvent-soluble type fluororesins. For example, copolymers of TFE/isobutylene/hydroxybutyl vinyl ether/additional monomer, copolymers of TFE/vinyl versatate/hydroxybutyl vinyl ether/additional monomer, copolymers of TFE/VdF/hydroxybutyl vinyl ether/additional monomer, and the like may be cited; of these, copolymers of TFE/isobutylene/hydroxybutyl vinyl ether/additional monomer and copolymers of TFE/vinyl versatate/hydroxybutyl vinyl ether/additional monomer are especially preferred for their excellent properties of pigment dispersibility, copolymerizability, weatherability, chemical resistance, and the like. As TFE based curing copolymers of this type, there may be given by way of example the ZEFFLE GK® series made by Daikin Industries Ltd. As other applicable curing functional group-containing fluoro-olefin polymers, there may be given by way of example copolymers of CTFE/hydroxybutyl vinyl ether/additional monomer, or the like, specific examples being LUMIFLON® made by Asahi Glass Co., Ltd.; FLUONATE® made by DIC Corporation; CEFRAL COAT® made by Central Glass Co., Ltd.; ZAFLON® made by Toa Gosei Co., Ltd., and the like.

Known methods are employed to disperse and admix light-reflectiving pigments into these solvent-soluble type fluororesins, if needed, adding, during preparation, defoaming agents, leveling agents, thickeners, delustering agents, suspending agents, dispersants, curing agents, curing accelerators, UV absorbers, photostabilizers, solvents, anti-staining agents (the hydrolyzable fluoro-organosiloxanes shown by way of example in WO 96/26254, Japanese Laid-Open Patent Application 2004-10832, and the like), or the like, for employment as the light reflecting coating compound composition essential to the present invention. Applicable curing agents and/or curing accelerators include the isocyanate based or melamine based curing agents given by way of example in Japanese Laid-Open Patent Application 2010-247522 (paragraph <0028>) and/or in Japanese Laid-Open Patent Application 2007-35694 (paragraphs <0054>-<0055>); aluminum based or tin based organometallic catalysts; or acid based or amine based catalysts.

### <8-1-2> Aqueous Dispersion Non-crosslinking Fluororesins

Due to properties such as excellent weatherability, chemical resistance, ease of production, ease of coating compound preparation, ease of coating operation, and the like, the fluorine-containing copolymer aqueous dispersion disclosed in WO95/08582 (Japanese Patent Application No. 7-509677) (paragraphs <0005>-<0013> of the Best Mode for Carrying Out the Invention section), obtained by seed polymerization of 20-100 parts (herein, refers to parts by weight) of acrylic acid ester and/or methacrylic acid ester, in the presence of 100 parts of particles of a fluorine-containing copolymer containing 70-95% vinylidene fluoride (VdF) and 5-30% chlorotrifluoroethylene (CTFE), in an aqueous dispersion containing the copolymer particles, and containing as an optional copolymer component a third copolymerizable monomer besides VdF and CTFE, can be cited as a preferred example of this aqueous dispersion type crosslinking fluororesins. As the third copolymerizable monomer, there may be cited TFE, vinyl fluoride (VF), hexafluoropropylene (HFP), trifluoroethylene (TrFE) and the like, it being preferable to employ TFE. Multiple third monomers may be employed. The content of the third copolymerizable monomer is 0-30%, preferably 10-25%, and more preferably 10-20%. As VdF based copolymers of this type, there may be given by way of example the ZEFFLE SE® series made by Daikin Industries Ltd., for example.

For these aqueous dispersion type noncrosslinking fluororesins as well, known methods may be employed to disperse and admix light-reflectiving pigments therein, if needed, adding, film formation aids, antifreezing agents, delustering agents, defoaming agents, leveling agents, pH adjusters, suspending agents, dispersants, preservatives, UV absorbers, photostabilizers, or the like during preparation, for employment as the light reflecting coating compound composition essential to the present invention.

### <8-1-3> Aqueous Dispersion Crosslinking Fluororesins

Aqueous dispersion type crosslinking fluororesins may also be cited as aqueous dispersion type fluororesins that can be applied in the present invention. In specific terms, there is, for example, the crosslinking-group containing aqueous dispersion type fluoro-olefin copolymer disclosed in WO 2007/071323 A1 (page 3, line 15 to page 8, line 11). Light-reflective pigments may be admixed into a dispersion of the crosslinking fluororesin obtained by these methods, doing so in the same manner as with the aqueous dispersion type non-crosslinking fluororesins mentioned above in <8-1-2>, admixing an essential water-dispersible curing agent given by way of example in the same publication (page 8, line 27 to page 13, line 19), and if needed, adding curing accelerators, film formation aids, antifreezing agents, delustering agents, defoaming agents, leveling agents, pH adjusters, suspending agents, dispersants, preservatives, UV absorbers, photostabilizers, or the like during preparation, for employment as a light reflecting coating compound composition.

### <8-2> Light-reflective pigments

As light-reflectiving pigments, there can be given by way of example those listed, for example, in Japanese Laid-Open Patent Application 2010-247522 (paragraphs <0015>-<0019>). In specific terms, inorganic light-reflectiving pigments or organic light-reflectiving pigments having excellent light reflection efficiency in the infrared region, or some combination of these, are applicable.

Known inorganic pigments such as, for example, finely powdered glass, glass balloons, ceramic beads, and other such ceramic pigments; aluminum and/or iron, zirconium, cobalt, and other such finely-divided metal pigments; titanium oxide, magnesium oxide, barium oxide, calcium oxide, zinc oxide, zirconium oxide, yttrium oxide, indium oxide, sodium titanate, silicon oxide, nickel oxide, manganese oxide, chromium oxide, iron oxide, copper oxide, cerium oxide, aluminum oxide, and other such metal oxide pigments; iron oxide-manganese oxide, iron oxide-chromium oxide, copper oxide-magnesium oxide, and other such complex oxide pigments; and Si and Al and/or Fe, magnesium, manganese, nickel, titanium, chromium, calcium, and other such metal pigments; as well as iron-chromium, bismuth-manganese, iron-manganese, manganese-yttrium, and other such alloy pigments, or mica, silicon nitride, coating pigments having undergone surface treatment, luster pigments, barium sulfate, calcium sulfate, and the like, can be employed individually or in combinations of two or more in the present invention.

As the organic pigments, those that, for example, absorb light in the visible region and have high reflectance of light in the infrared region, for example, by way of example, reflectance of 10% or above, are preferred. There can be given by way of example, any one, or two or more, of azo pigments, azomethine pigments, lake pigments, thioindigo pigments, anthraquinone pigments (anthanthrone pigments, diaminoanthraquinonyl pigments, indanthrone pigments, flavanthrone pigments, anthrapyrimidine pigments, and the like), perylene pigments, perinone pigments, diketopyrrolopyrrole pigments, dioxazine pigments, phthalocyanine pigments, quiniphthalone pigments, quinacridone pigments, isoindoline pigments, isoindolinone pigments, and the like.

As specific examples of inorganic pigments and organic pigments, there may be cited the FASTOGEN® series made by made by DIC Corporation; the infrared-reflecting pigments made by Cerdec Corporation, the CHROMOFINE® series and the DAIPYROXIDE® series made by Dainichi Seika Color & Chemicals Mfg. Co. Ltd., the ARTIC® series made by The Shepherd Color Company, titanium oxide made by Sakai Chemical Industry Co. Ltd., titanium oxide made by Ishihara Sangyo Kaisha Ltd. (the TIPAQUE® series), and the titanium oxide made by the Dupont Corporation (the TI-PURE® series), as well as titanium oxide made by Huntsman Corporation (the TIOXIDE® series), and the like. However, there is no limitation to these, and a plurality of these light reflecting pigments may be used in combination.

From the standpoint of imparting high light reflecting ability in particular, titanium dioxide, which is a white pigment, is preferred among the light-reflecting pigments. Either the anatase form or the rutile form is acceptable, but from the standpoint of good weatherability for prolonged periods in the case of use in outdoor environments, the rutile form is preferred. Typically, the white pigment titanium dioxide has a strong oxidizing action, and therefore in the case of being admixed with general purpose, non-fluororesin, degradation of the film tends to be accelerated. In the present invention, however, it is employed by being admixed with a fluororesin, and therefore it is possible to maintain good weatherability and reflecting capability of the light-reflecting film layer for prolonged periods.

The mean particle size of the light-reflectiving pigment may be established arbitrarily according to the particular application and/or coating conditions and the like, and is not particularly limited; however, from the standpoint of the appearance and/or capabilities of the coating film obtained by the coating operation, the particle size is preferably 50 µm or less, and more preferably 10 µm or less, as measured with a grind gauge as disclosed in JIS K5600 2-5. By making the particle size is 50 µm or less, surface roughness of the skin of the dry coating film is minimized, making the appearance better. Specifically, by minimizing surface roughness of the skin of the dry coating film, adhesion of dust onto the rough surface can be avoided, and good light reflecting ability can be maintained, whereby deterioration in heat insulating properties can be minimized. Moreover, even in cases of a rise in the coating film surface temperature when under the sun, the tendency for soils to adhere thereby can be avoided, and good aesthetic qualities, soiling resistance, weatherability, and the like can be attained.

While there is no particular limitation as to the admixed amount of the light-reflectiving pigment (the total amount of organic pigments and inorganic pigments, including titanium dioxide), from the standpoint of ensuring a balance between the light reflecting characteristics, and the hiding power, aesthetic qualities, coating operability, and the like of the coating film, the admixture ratio is preferably 10 to 400 mass parts, more preferably 30 to 300 mass parts, and still more preferably 50 to 200 mass parts, per 100 mass parts of fluororesin in the coating film. Setting the admixture ratio to 10 mass parts or above can more sufficiently ensure light reflecting ability and/or base material hiding power. By setting <the admixture ratio> to no more than 400 parts, better ease of coating compound preparation, appropriate dispersed particle size, ease of coating operation, coating film smoothness, and the like can be attained.

Other commonly used pigments and/or fillers may be admixed, at levels that do not diminish the heat insulating effect. Calcium carbonate, magnesium carbonate, clay, and the like can be indicated as examples of other pigments and/or fillers, for example.

### <8-3> Coating Compound and Coating Film

The coating compound composition of the present invention, which contains a fluororesin and a light-reflectiving pigment, can be prepared employing a sand grinder, a ball mill, a bead mill, a paint shaker, a three roll, a centrifugal mixing apparatus, or other such known dispersing apparatus. During the process, if needed, suspending agents, dispersants, diluents, delustering agents, leveling agents, defoaming agents, thickeners, preservatives, solvents, UV absorbers, photostabilizers, overcoat adhesion improvers, and the like can be admixed. In the case of preparation of a base of crosslinking type from among the solvent-soluble fluororesins mentioned above in <8-1-1>, or in the case of preparation of a base of an aqueous dispersion type crosslinking fluororesin mentioned above in <8-1-3>, a curing agent is admixed during the coating operation, optionally adding a curing accelerator, for the coating operation.

The coating compound prepared in this manner, in any of the first to third embodiments, is applied onto the base material 22 to form the coating film 21, or in the sixth embodiment, is applied to the roof 30 to form the coating film 620. A sealer application, base coat application, or middle coat application may be performed prior to the aforedescribed coating operation. The coating compound for the base coat and/or the coating compound for the middle coat may be selected as appropriate for the type of base material and/or the condition of the base material surface prior to the coating operation, with no particular limitations, and known water-based or solvent-based epoxy resins, modified epoxy resins, acrylic resins, curing type acrylic resins, urethane resins, acryl silicone resins, inorganic coating compounds, and the like can be applied. Provided that cohesion of the base material and/or the light-reflectiving pigment-containing fluororesin topcoat layer is not impaired during the coating operation, it is preferable from the standpoint of the load on the environment, particularly during outdoor coating operations, to employ water-based coating materials. However, in the absence of problems such as penetration into the base material surface or into existing old coating film, if needed, solvent-based materials are applicable as well. Whereas there are no particular limitations as to the pigment and/or coating color employed in the base coat and middle coat, while it is not essential to do so, when the light-reflectiving pigments mentioned above in <8-2> are included in the coating compound compositions of the base coat and middle coat as well, heat accumulation in the base coat layer or middle coat layer, due to minute infrared transmitted through the light-reflecting layer furnished to the outermost layer in the embodiments of the present invention, can be minimized, which is preferable from the standpoint of aiding the heat insulation obtained in the embodiments of the present invention. In preferred practice, the coating color is such that the lightness value of the dry coating film (the L* value specified by the CIE (International Commission on Illumination)), measured by a colorimetric color difference meter) is about 80 or above, preferably 85 or above, more preferably 90 or above; or is an achromatic color (a color that is simply light or dark, lacking any saturation in the Munsell color space, specifically, defined as a mixture of white and black) having a Munsell value (stipulated in JIS Z8102 (2008)) of N8 or above, more preferably N8.5 or above, and still more preferably N9 or above. By setting the coating color lightness value L* to 80 or above or the Munsell value to N8 or above, heat accumulation due to minute infrared can be minimized in the manner described above, effectively aiding the heat insulating properties.

Known methods may be employed as the method for the coating operation. For example, there may be cited a brush, a hand roller, an auto-feed roller, an air spray, an airless spray, a flow coater, a roll coater, a spin coater, or the like.

The coating temperature may be one within the range of conditions normally prevailing in a given modality of coating. In the case of a solvent-type coating compound, drying or curing of the coating film is carried out at 10 to 300°C, and typically normal temperature (20 to 30°C). In the case of a water-based coating compound composition, it is carried out at 10 to 100°C, and typically normal temperature (20 to 30°C). With either type of coating compound composition, optional adjustments may be performed, as appropriate.

The required dry film thickness of the light-reflecting coating film (for the fluororesin base coating film layer of the outermost surface layer, excluding the sealer, the base coat, the middle coat, and so on), once formed, will differ depending on various factors such as the intended application, the coating operation method, and the like, and is not particularly limited, but is preferably 5 to 400 µm, more preferably 2 to 200 µm, and still more preferably 30 to 100 µm. By setting the film thickness to 5 µm or greater, the occurrence of coating defects during the coating operation is minimized, affording greater resistance to the effects of moisture and other factors that induce degradation, and making it possible to confer durability for a more prolonged period. On the other hand, by setting the film thickness to 400 µm or less, poor elimination of air bubbles during thick coating operations is avoided, sag of the coating film is minimized, and the coating properties and/or the final finished skin are better, such as better drying properties of the coating film, and the like. When it is difficult to ensure the required film thickness is achieved in a single coating operation procedure, appropriate adjustments may be made by division/repetition of the coating operation.

The light-reflecting properties of the obtained coating film, as measured and calculated according to JIS K5602 (2008), are such that solar reflectance in the 780-2500 nm wavelength range is preferably 50% or above, more preferably 60% or above, and still more preferably 70% or above.

There are no particular limitations as to the thickness of the base material 22 in the first to third embodiments, provided that the thickness is sufficient for shape retention when disposed beneath solar cells.

### <9> Details of Base Material 22 of First, Second, Third and Fifth Embodiments

The base material 22 employed may be one commonly employed in construction, with no particular limitations. For example, there may be given as examples polyester, FRP, polyurethane, polyvinyl chloride, polycarbonate, and other such plastic base materials; zinc (galvanization), galvalume steel sheeting, tin plate, ferric steel, aluminum, stainless steel, and other such metal base materials; bitumen, slate, ALC panels, flexible boards, concrete blocks, mortar, gypsum panels, concrete, plaster, and other such ceramic materials; and cardboard, china veneer, lauan wood, hardwood single panels, softwood single panels, and other such wood base materials.

### <10> Details of Reflecting Panel 420 of Fourth Embodiment

In the present embodiment, rather than applying the fluororesin coating composition in a coating operation, as another acceptable method, a light-reflecting pigment is admixed into a thermoplastic resin in advance by known methods, and melted and molded under applicable conditions to fabricate a light-reflecting member of appropriate shape, for example, a film, sheet, board or the like, which is installed in a prescribed area of a structure, and a solar cell module furnished thereabove.

As applicable thermoplastic resins, polytetrafluoroethylene (PTFE), TFE/perfluoroalkyl vinyl ether (PAVE) copolymer (PFA), TFE/hexafluoropropylene (FEP), ethylene (Et)/TFE copolymer (ETFE), polychlorotrifluoroethylene (PCTFE), polyvinylidene fluoride (PVdF), vinylidene fluoride (VdF)/tetrafluoroethylene copolymer (TFE), VdF/TFE/hexafluoropropylene (HFP) copolymer, VdF/TFE/chlorotrifluoroethylene (CTFE) copolymer, polyvinyl fluoride (PVF), and other such fluoro-olefin polymers, are preferred from the standpoint of excellent ease of procurement, ease of hot working, weatherability, water resistance, chemical resistance, soil elimination properties, and the like.

Of these, TFE/perfluoroalkyl vinyl ether (PAVE) copolymer (PFA), TFE/hexafluoropropylene (FEP), ethylene (Et)/TFE copolymer (ETFE), polychlorotrifluoroethylene (PCTFE), polytetrafluoroethylene (PTFE), and the like are further preferred from the standpoint of excellent ease of hot working and chemical stability in particular.

The aforementioned light-reflecting pigment, and any optional adjuvant materials (for example, fillers, antioxidants, dispersion stabilizers, processing additives, and the like) as necessary are admixed into these resins, which can then be formed into a sheet or board profile by treatment at a temperature at least equal to or above the melting point of the fluororesin, but less than 400°C, employing, for example, an extrusion molding method and/or a compression molding method. In cases in which, of the aforementioned applicable thermoplastic fluororesins, polytetrafluoroethylene (PTFE) is employed, a compression molding method can be preferably applied, or in the case of another <fluororesin> such as PFA, FEP, ETFE, PCTFE, or the like, an extrusion molding method or a compression molding method can be preferably applied. The molding obtained thereby may be installed directly in a target area of a structure and employed as the sunlight-reflecting member of the present invention; or may be secured beforehand to a prescribed base material by thermocompression bonding and/or adhesion employing known adhesives, or the like, and employed as the reflecting member. The thickness of the molding board or sheet is not particularly limited, and may be selected as appropriate depending on the intended application and/or conditions, but is preferably 0.01 to 50 mm, and more preferably 0.05 to 40 mm, from the standpoint of ease of molding, mechanical toughness, production cost, and the like. 1 to 30 mm is still more preferred. By selecting a value of 0.01 mm or above, ease of molding and mechanical toughness can be made more sufficient. By selecting a value of 50 mm or less, production costs and weight per unit of surface area can be minimized.

As a separate known method, the essential light-reflecting pigment, plus any optional adjuvant materials as necessary (for example, fillers, defoaming agents, antioxidants, dispersion stabilizers, processing additives, and the like), are admixed into these polymer aqueous dispersion to prepare a thermoplastic fluororesin composition, which is applied through impregnation to architectural-grade inorganic fabric, such as glass cloth or the like, and baked at least at a temperature at or above the melting point of the fluororesin but less than 400°C, to obtain a building material film in which the fluororesin covers the architectural-grade inorganic fabric so as to be supported thereon. This can then be installed on a target structure, and employed as the light-reflecting layer of the present invention. The quantity applied through impregnation to the fabric is not particularly limited and may be selected appropriately depending on the thickness of the fabric, and/or the intended application and conditions; however, from the standpoint of base material hiding power, durability, finished appearance, and the like, the dry application quantity is 5 to 1000 g/m², preferably 50 to 700 g/m², and more preferably 100 to 500 g/m², By setting the application quantity to 5 g/m² or more, the occurrence of deficient hiding and/or film formation defects is minimized, making it possible to further better the durability (to minimize degradation of the fabric due to infiltrating water and/or ultraviolet and the like). A value of 1000 g/m² or less affords good hand and feels on the part of the impregnated fabric which is ultimately obtained, give a good finish skin, and makes it possible to keep production costs low. During application through impregnation to the inorganic fabric, in preferred practice, the procedure is carried out through division/repetition and baking, to build up layers incrementally until the prescribed dry application quantity is obtained. Through this technique, the occurrence of mud cracks during film formation through baking is minimized, and there can be obtained a film building material covered by a light-reflective fluororesin of higher quality and few film defects.

### <11> Details of Coating Film 520 of Fifth Embodiment and Coating Film layer 720 of Seventh Embodiment

One embodiment of the present invention involves a method of furnishing a base material with a coating film layer containing essentially a non-fluorine based, film-forming resin and a light-reflecting pigment thereon, and then applying, by a coating operation or by lamination, a clear fluororesin layer that does not contain colored pigment. Furnishing a so-called top clear film layer of a fluororesin over the light-reflecting layer of a general-purpose resin base is advantageous in terms of reducing total coast. The non-fluorine based, film-forming resin is preferably one soluble in organic solvents or dispersible in water, capable of film formation at normal temperature through a coating operation, or capable of forming a dry film at a temperature of about 30 to 300°C; various known ones are applicable.

There may be given as examples thereof resins such as those in Japanese Laid-Open Patent Application 2010-247522 (paragraph <0021>-<0022>), which discloses alkyd resins, acrylic resins, acryl silicone resins, urethane resins, amide resins, melamine resins, ether resins, vinyl chloride resins, polyester, polystyrene, polyolefin, polyacetal, polycarbonate, polyphenylene resins, silicone resins, and other such solvent-soluble resins; vinyl acetate resins, water-soluble or water-dispersible acrylic resins, silicone-modified acrylic resins, water-soluble or water-dispersible fluororesins, water-soluble or water-dispersible urethane resins, water-soluble or water-dispersible melamine resins, water-soluble or water-dispersible polyester, and other such water-soluble or water-dispersible resins, as well as inorganic resins for coating compound use. Of these, from the standpoint of excellent ease of procurement, ease of handling, durability, heat resistance, light resistance, chemical resistance, and the like, urethane resins, acrylic resins, acryl silicone resins, and silicone resins are preferred. The light-reflectiving pigments and other optional adjuvant materials mentioned previously in <8-2> may be admixed by techniques comparable to those mentioned previously in <8-3> into these and prepare a coating compound composition, in the coating operation. Like that discussed previously, the coating operation in that case may involve a technique of performing a coating operation on a target area at the site of an existing structure, or a technique of obtaining a constituent element of a structure in advance by a coating operation onto a base material at the factory, and installing the constituent element thusly obtained in a target area of the structure. In this way, a modality having a clear fluororesin layer as a top layer over a light-reflecting layer can be obtained by furnishing the non-fluororesin base with a light-reflecting layer in advance, followed by a top clear coating operation with a filmforming fluororesin coating composition that does not contain a light-reflecting pigment or other colored pigment.

Fluororesins applicable as the top clear layer include the solvent-soluble fluororesins or aqueous dispersion type fluororesins given as examples in the preceding description in <8-1-1> and <8-1-2>. Clear coating compound compositions may be prepared in the same manner as described previously in <8-3>, optionally admixing adjuvant materials, except that no light-reflecting pigment or other colored pigment is admixed therein. A clear coating film of a fluororesin typically has high light transmittance, and from the standpoint of minimizing degradation induced by transmitted ultraviolet in the light-reflective, non-fluororesin based film positioned to the lower side of this layer, it is preferable to admix UV absorbers, photostabilizers, or other such additives for inhibiting photodegradation, either individually or concomitantly, into the fluororesin coating composition for the top clear coating operation, although it is not essential to do so depending on the intended application and/or project environment. The total added quantity thereof is 0.1 to 30 mass parts, preferably 0.5 to 20 mass parts, and still more preferably 1 to 10 mass parts, with respect to 100 mass parts of fluororesin in the top clear layer. With a quantity of 0.1 mass part or more, sufficient photodegradation inhibiting effect can be obtained. With a quantity of 30 mass parts or less, with no loss of film-forming properties during the coating operation, tacky feel due to an oil film-like layer arising on the coating film surface or the like can be minimized, and resistance to adhesion of soil outdoors can be imparted. The coating operation of this top clear composition can be performed by a technique comparable to those discussed previously in <8-3>.

### <12> Evaluation

The test methods and measurement methods employed to evaluate each of the aforedescribed embodiments were as follows.

### (Solar reflectance)

This can be evaluated from solar reflectance in the 780-2500 nm wavelength range, measured and calculated by the method disclosed in JIS K5602 (2008)

### (Soiling resistance)

Soiling resistance can be evaluated on the following criteria.

Conditions for evaluating soiling resistance through outdoor exposure: a test panel (of arbitrary dimensions) was installed on a stainless steel exposure stage oriented facing south at a 30 degree incline in Osaka prefecture, and exposed outdoors until a difference from a comparison specimen was apparent. Observations of visual appearance and solar reflectance (JIS K5602 technique) were made before and after exposure.

Specimens having less adhering soil in visual examination, and retaining higher solar reflectance, were evaluated as having better soiling resistance.

### (Weatherability)

Weatherability can be evaluated by the following outdoor exposure technique or accelerated weatherability evaluation technique.

Outdoor exposure: by a method essentially identical to the aforedescribed outdoor soiling resistance test, change over time in specimens was observed. Judgments are made in relation to evaluation items relevant to surface layer degradation other than soil adhesion (dulling, discoloration, cracking, chalking (a powdery coating caused by exposure of pigment to the surface layer from the interior of the coating film), and the like).

Accelerated weatherability: specimens ware tested in an EYE SUPER UV tester (a super-accelerated weatherability tester made by Iwasaki Electric Co. Ltd.) for 644 hours in an irradiation/condensation/rest (11 hr/11 hr/1 hr, shower frequency during irradiation was 10 sec/1 hr) cycle, observing changes over time in the specimen surface in the same manner. Average illuminance during the test was 100 mw/cm²; settings for temperature and humidity conditions are given in Table 1 below.

**<Table 1>**

| | Black panel temperature (°C) | Relative humidity (%) |
|---|---|---|
| Irradiation | 63 | 70 |
| Condensation | Normal temperature | 100 |
| Rest | 63 | 85 |

### <Working Examples>

Working examples of the present invention and the effects thereof are described below, but are not intended to limit the present invention.

### Working Example 1:

(1) Preparation of aqueous dispersion type fluororesin coating compound composition (topcoat coating compound) containing light-reflecting pigment:
64.78 mass parts of a vinylidene fluoride copolymer aqueous dispersion (ZEFFLE SE-405 made by Daikin Industries Ltd.) were weighed into a container. Employing a propeller type stirrer, under stirring at 300 rpm, 4.83 mass parts of a film-formation aid (dimethyl adipate), 0.59 mass part of 28% concentration aqueous ammonia, and 27.79 mass parts of a light-reflecting pigment millbase prepared beforehand to the formulation of Table 2 below were added, stirring for 30 minutes. Thereafter, 1.91 mass parts of a polyurethane type thickener solution (ADEKANOL UH420 made by Adeka Corporation, prepared to 10 mass% concentration with deionized water) and 0.1 mass part of a silicone defoaming agent (DC 65 ADDITIVE made by Dow Coming Corporation) were added, stirring for a further 30 minutes, to obtain the aqueous dispersion type fluororesin coating compound composition containing a light-reflecting pigment of Working Example 1.

**<Table 2>**

| Light-reflecting pigment millbase formulation | | | |
|---|---|---|---|
| Material | Brand | Maker | Formulation (mass%) |
| Deionized water | | | 10.35 |
| Dispersion stabilizer | Dispersant SN-5027 | San Nopco Japan | 5.25 |
| Ethylene glycol | | | 4 |
| Rutile titanium dioxide (light-reflecting pigment) | Tipaque CR-97 | Ishihara Sangyo Kaisha, Ltd. | 70 |
| Silicone defoaming agent | DC 65 ADDITIVE | Dow Coming Corporation | 0.3 |
| Hydroxyethyl cellulose thickener | Tylose H400P | Clariant | 10 |
| Aqueous ammonia (28% conc.) | | | 0.1 |

| | | | |
|---|---|---|---|
| Remarks: To a total of 100 mass parts of the composition in the above table were added 80 mass parts of glass beads of 1.5 mm average diameter. Employing a three-cylinder type sand grinder (made by Aimex Corporation), a light-reflecting pigment mill base was obtained by dispersion for 1 hour at 1000 rpm, followed by screening through an 80 mesh stainless steel screen. | | | |

(2) Preparation of water-based two-pack type epoxy undercoat coating compound composition
100 mass parts of a commercially available water-based two-pack type epoxy undercoat coating compound (HLG System Specialty Primer Super pack A and pack B, made by Cosmo Technology, premixed in a 1 to 1 ratio by volume) was weighed out into a container, and 30 mass parts of the light-reflecting pigment mill base of Table 2 were admixed to obtain a water-based two-pack type epoxy undercoat coating compound composition containing the light-reflecting pigment. (3) Fabrication of test piece coated with light-reflective aqueous dispersion type fluororesin coating compound

The water-based two-pack type epoxy undercoat coating compound composition prepared as described above in (2) was applied with a brush to a bitumen base material (DERBIBRITE NT made by Imperbel S.A. -Derbigum) to a wet coating quantity of about 300 g/m², and dried for one day at room temperature. Thereafter, a topcoat of the water-based fluororesin coating compound composition containing the light-reflecting pigment prepared to the aforedescribed formulation in advance was applied with a brush to a wet coating quantity of about 150 g/m², and dried for one day at room temperature. Thereafter, a topcoat was reapplied with a brush in the same manner. Following two topcoat coating operations in this manner, the test piece of Working Example 1 (dimensions 8 cm x 28 cm) was fabricated through drying for 7 days at room temperature.

### Comparative Example 1:

A piece cut to the same dimensions from a light-reflective white polyolefin film material (trade name FLAGON TPO, made by Soprema-klewa Gmbh Division FLAG Hochpolymere Abdichtungen) was prepared.

### Comparative Example 2:

A piece cut to the same dimensions from uncoated bitumen base material was prepared.

### (Soiling resistance evaluation)

Using a spectrophotometer (U-4100 made by Hitachi Ltd.), solar reflectance in the 780-2500 mm wavelength range before outdoor exposure was determined by the technique of JIS K5602, for the test panels of Working Example 1, Comparative Example 1, and Comparative Example 2.

After determining a pre-test initial value for each of the test pieces in this way, the test pieces were installed on a stainless steel exposure stage oriented facing south at a 30 degree incline in Osaka, and exposed outdoors for three months. After exposure, each test piece underwent observation of the visual appearance thereof, in comparison to reserve test pieces of the working example and the comparative examples, respectively, which had been kept in reserve beforehand. Solar reflectance subsequent to exposure was determined in the same manner as previously by the technique of JIS K5602. The extent of decline in solar reflectance was determined from the difference of the initial value prior to exposure and the value subsequent to exposure. Herein, specimens having less adhering soil in visual examination, and retaining higher solar reflectance even after exposure, were decided to have better soiling resistance.

Test panels of Working Example 1, Comparative Example 1, and Comparative Example 2 were prepared separately from those employed in outdoor exposure. These were tested in the aforedescribed EYE SUPER UV tester (super-accelerated weatherability tester made by Iwasaki Electric Co. Ltd.) for 644 hours in an irradiation/condensation/rest (11 hr/11 hr/1 hr, shower frequency during irradiation was 10 sec/1 hr) cycle, and accelerated weatherability evaluations were made. In specific terms, visual appearance (observation of changes over time in the specimen surface, such as the extent of dulling, discoloration, presence/absence of cracking, and the like); the extent of discoloration (the color difference Δ*E determined by the equation specified by the CIE (International Commission on Illumination, employing a color and color difference meter); and chalking (the extent of transferred matter when touched with the fingers, and when transparent adhesive tape is peeled in accordance with JIS K5600-8-6) were observed. Specimens for which changes over time in these were slight were decided to have better weatherability.

The results obtained are shown below in Table 3.

**<Table 3>**

| Soiling resistance with outdoor exposure in the working example | | | |
|---|---|---|---|
| Item | Working Example 1: (water-based fluororesin coating compound-coated bitumen) | Comparative Example 1: (light-reflective white polyolefin film material) | Comparative Example 2: (uncoated bitumen) |
| Visual appearance (after exposure) | Compared to before exposure, only very slight soil adhesion | Compared to before exposure, marked soil adhesion (mottled soil) | Marked decolorization and whitening |
| Solar reflectance % (before exposure) | 83 | 72 | 16.1 |
| Solar reflectance % (after exposure) | 79.8 | 65 | 15 |
| Extent of decline in solar reflectance after exposure (extent of decline = reflectance before exposure - reflectance after exposure) | 3.2 | 7 | 1.1 |
| Accelerated weatherability | | | |
| Visual appearance Extent of discoloration (color difference Δ*E) | Nothing unusual | Dulling, yellowing | Marked decolorization and whitening |
| Chalking | 0.3 | 4.3 | 5.6 |
| | No | Yes (white transferred matter slightly noted when touching with fingers/peeling tape) | Yes (white transferred matter noted when touching with fingers/peeling tape) |

| | | | |
|---|---|---|---|
| Remarks: Bitumen base material was gray prior to coating | | | |

As disclosed in the above table, in Working Example of the present invention, soil adhesion visually observed subsequent to exposure was slight, the change in solar reflectance before and after exposure was minimal, and change over time in the accelerated weatherability test was minimal, therefore leading to the finding of clear superiority to the polyolefin rubber based light reflecting sheet of Comparative Example 1. With the uncoated bitumen of Comparative Example 2, due to the gray color of the base material, soil adhesion subsequent to exposure did not stand out visually, but the base material itself upon visual inspection was found to have marked decolorization and whitening. A tendency similar to this phenomenon was indicated in the results of the accelerated weatherability test as well, meaning that the progress of degradation caused by outdoor environmental factors such as ultraviolet, heat, moisture, and the like was marked during three-month outdoor exposure and/or the accelerated weatherability test. Therefore, Working Example 1 is distinguished from the Comparative Example 2 from the standpoint of weatherability as well.

The preceding suggests that the working example of the present invention excels in soiling resistance, weatherability, and continuance of sunlight reflecting ability, and is useful in terms of prolonged durability and maintaining power generation efficiency of solar cells.

### Working Example 2 and Comparative Example 3:

An evaluation of the contribution to power generation efficiency in a solar cell system by combining the light-reflecting layer of the present invention therewith was made by the following technique.

Test sections (100 m² each) were furnished at two sites on the rooftop of a net zero energy building in Herten, Germany.

In one of the sections, a bitumen base material (DERBIBRITE NT made by Imperbel S.A.-Derbigum) was installed over the flat roof, and an aqueous dispersion type fluororesin coating compound containing a light-reflecting pigment next was applied.

In essence, the coating operation involved brush application of a predetermined quantity of the water-based two-pack type epoxy undercoat disclosed previously in Working Example 1-(2) (the same applied quantity as in the aforedescribed Working Example 1) and drying for one day at normal temperature, then applying with a brush two overcoats of a predetermined quantity of the aqueous dispersion type fluororesin coating compound composition containing a light-reflecting pigment (containing ZEFFLE SE-405 made by Daikin Industries Ltd. as the base resin) disclosed previously in Working Example 1-(1) (the same applied quantity as in the aforedescribed Working Example 1) dried at one day intervals at normal temperature, followed by drying for one week. A "Solyndra® Solar SL001-182" flat roof solar cell system made by Alwitra Gmbh/Solyndra was installed over this coated bitumen base material. This was designated as Working Example 2.

As a comparison, a light-reflective white polyolefin rubber film material (trade name FLAGON TPO, made by Soprema-klewa Gmbh Division FLAG Hochpolymere Abdichtungen) was installed over the flat roof in the other section, and a "Salyndra® Solar SL001-182" was installed thereover in the same manner as in Working Example 2. This was designated as Comparative Example 3.

The above described two solar cell systems of Working Example 2 and Comparative Example 3 were connected to a single inverter. In this state, the measurements discussed below were made, in order to observe the effects of contribution to the quantity of power generated, by virtue of having furnished the coating film obtained by application of the aqueous dispersion type fluororesin coating compound containing the light-reflecting pigment.

### i)

The direct current of the solar cells (measured before the inverter) was observed for four months from June through the end of September, comparing Working Example 2 of the bitumen base material to which the aqueous dispersion type fluororesin coating compound containing the light-reflecting pigment was applied, and Comparative Example 3 employing the light-reflective white polyolefin rubber film material. The respective current values were measured by a measuring box constituted by an LEM LTS 6-NP current transducer (made by LEM Corp.) as the main component. The results of a comparison of the total amount of distributed power obtained is shown in Table 4.

**<Table 4>**

| Difference in total amount of generated and distributed power in Working Example 2 and Comparative Example 3, and improvement in power generation of Working Example 2 in relation to Comparative Example 3 | | |
|---|---|---|
| Item | Working Example 2: (water-based fluororesin coating compound-coated bitumen) | Comparative Example 3: (light-reflective white polyolefin rubber film material) |
| Total amount of generated and distributed power (A · hr) | 2411 | 2205.9 |
| Improvement in power generation (%) | 9.3% (value based on total amount of generated and distributed power of Comparative Example 3) | - |

As may be appreciated from Table 4, Working Example 2 of the bitumen base material to which the aqueous dispersion type fluororesin coating compound containing the light-reflecting pigment was applied was found to improve the amount of distributed power by about 9.3%, with respect to Comparative Example 3 employing the light-reflective white polyolefin rubber film material which was the comparison section.

### ii)

The output voltage, which is one index of the power generation efficiency of a solar cell, is typically susceptible to the effects of temperature. Specifically, higher output voltage is more readily obtained when the temperature of the module itself is maintained at a low value. A Thermasgard ATM-1-U sensor (made by S+S Regeltechnik Gmbh) was connected to each of the solar cell modules of Working Example 2 and Comparative Example 3 (the aforementioned Solyndra module), and the temperature in the vicinity of the modules was measured. The temperature in the vicinity of the modules was measured in terms of air temperature in the vicinity of the surface of the solar cells on the side exposed to sunlight. The drop in temperature (degrees Celsius) in the case of Working Example 2 with respect to the temperature of Comparative Example 3 (comparison section) for a one-week period from 6/13 to 6/19 is shown in Table 5. In specific terms, the average temperature differential and the maximum temperature differential between 8:00 and 18:00 were observed.

**<Table 5>**

| Drop in temperature in vicinity of module of Working Example 2 with respect to temperature in vicinity of module of Comparative Example 3 | | |
|---|---|---|
| | Average temperature drop (°C) | Maximum temperature drop (°C) |
| Weekly average | 4.5 | 10.2 |

As may be appreciated from Table 5, in Working Example 2, a drop of 4.5 degrees in the weekly average temperature and of 10.2 degrees in maximum temperature with respect to Comparative Example 3 were confirmed, confirming that, in Working Example 2, the effect of markedly reducing the module temperature with respect to Comparative Example 3 can be obtained. This result suggests that the system disclosed in the present invention is extremely advantageous in boosting power generation efficiency, from the standpoint of module temperature as well.

### INDUSTRIAL APPLICABILITY

The present invention is extremely useful as a solar cell system for utilizing reflected light as well. At the same time, the light-reflecting layer minimizes the quantity of heat penetrating into the building, which can contribute to improving the environment of spaces of human activity, and reducing the load on the air conditioning system. In the present invention, a light-reflecting layer in which a fluororesin is an essential film-forming component is implemented in place of a hydrocarbon resin as employed in the past, thereby capable of contributing to overall durability (weatherability, soiling resistance, chemical resistance, water resistance, light-reflecting ability retention, and the like) in the light-reflecting layer. This may act extremely advantageously from the standpoint of developing higher power generation efficiency and maintenance thereof for prolonged periods, and, further, of maintaining heat insulation for prolonged periods. From this, one may envision potential implementation in various applications in which installation of this sort of power generation system is possible, and in which heat insulation is necessary. In specific terms, for example, increasing initiative in recent years to conserve and revitalize the environment on a global scale has led, in the architecture and environmental facility markets, to a rapid acceleration of painstaking research directed to net zero energy buildings (also called zero emission buildings, eco commercial buildings, and the like), specifically, to buildings based on the concept of relying on solar cells for most of the required power, basically not using any power from outside the building. As described hereinabove, the system of the present invention excels in durability, high power generation efficiency, and retention thereof for prolonged periods, and is therefore thought to have considerable utility to the field.

As other applications for implementation there may be cited homes, buildings (ordinary buildings, not the net zero energy buildings mentioned above), hotels, factories, chemical plants, shops, warehouses, hospitals, schools, airport facilities, port facilities, storage facilities (for example, those for oil, everyday articles, food and beverage products, and the like), the agriculture and livestock field (for example, livestock barns, chicken coops, food manufacturing/processing sheds, and the like), the transportation field (for example, ships, airplanes, automobiles, rolling stock, stationhouses, and the like), and the like. There is no limitation to the applications cited above by way of example.

### REFERENCE SIGNS LIST

- 1: Front surface protection layer
- 2: Sealing layer
- 3, 203: Power generating element
- 4, 304: Back surface protection layer
- 5: Power generating element
- 10, 210, 310, 410, 510, 610, 710: Solar cell
- 20: Light-reflecting panel
- 21: Coating film (light-reflecting layer)
- 22: Base material
- 30: Roof
- 100, 200, 300, 400, 500, 600, 700: Solar cell system
- 420: Light-reflecting panel
- 620: Coating film
- 720: Coating film layer

### CITATION LIST

### PATENT LITERATURE

- Patent Document 1:: Japanese Laid-Open Patent Application 2007-35694

## Claims

1. A solar cell system comprising:
solar cell; and
a reflecting layer disposed on the opposite side from the sunlight-incidence side of the solar cell, and including a fluororesin and a light-reflective pigment.

2. The solar cell system according to claim 1, wherein
the solar cell has a power generating element having a first photoreceptor part for receiving light on the sunlight-incidence side, and a second photoreceptor part for receiving light at the opposite side from the sunlight-incidence side.

3. The solar cell system according to claim 1 or 2, wherein
the fluororesin is a fluoro-olefin polymer having normal-temperature coating properties or melt molding properties.

4. The solar cell system according to any one of claims 1 to 3, wherein
the reflecting layer has a solar reflectance of 50% or higher in the 780-2500 nm wavelength range, as determined by the method of JIS K5602 (2008).

5. The solar cell system according to any one of claims 1 to 4, wherein
the reflecting layer is disposed at a distance from the solar cell.

6. The solar cell system according to any one of claims 1 to 5, further comprising a base material,
the reflecting layer being a coating film formed on the surface of the base material.

7. The solar cell system according to any one of claims 1 to 5, wherein
the reflecting layer is a molded resin formed by melt processing a thermoplastic fluororesin into which the light-reflectiving pigment is admixed; or
the reflecting layer has an inorganic fabric, the reflecting layer being constituted by melt processing a thermoplastic fluororesin into which the light-reflectiving pigment is admixed, and supported on the inorganic fabric.
